Europäisches Patentamt

European Patent Office

Office européen des brevets

(19)

(11) Publication number: **0 042 467**
**B1**

(12) **EUROPEAN PATENT SPECIFICATION**

(45) Date of publication of patent specification: **06.07.83**

(51) Int. Cl.³: **H 01 L 31/06**

(21) Application number: **81101069.3**

(22) Date of filing: **16.02.81**

(54) Tandem solar cell.

(30) Priority: **20.06.80 US 161550**

(43) Date of publication of application:
**30.12.81 Bulletin 81/52**

(45) Publication of the grant of the patent:
**06.07.83 Bulletin 83/27**

(84) Designated Contracting States:
**DE FR GB IT**

(56) References cited:
**DE - A - 2 854 750**
**US - A - 4 017 332**
**US - A - 4 179 702**

**IBM TECHNICAL DISCLOSURE BULLETIN, Vol. 21, No. 11, April 1979**
**New York**
**R. TSU et al. "New Type of Thin Film Hybrid Crystalline-Amorphous Si Solar Cell with High Light Absorption P-I-N Structure" page 4691**

(73) Proprietor: **International Business Machines Corporation**
**Armonk, N.Y. 10504 (US)**

(72) Inventor: **Hovel, Harold John**
**Diane Court**
**Katonah New York 10598 (US)**

(74) Representative: **Petersen, Richard Courtenay**
**IBM United Kingdom Patent Operations Hursley Park**
**Winchester Hants. SO21 2JN (GB)**

(56) References cited:
**VDI-ZEITSCHRIFT, Vol. 121, No. 8, April 1979 Düsseldorf**
**H. FREY et al. "Dünnschichtsolarzellen, eine Chance, Sonnenenergie wirtschaftlich in elektrische Energie umzuwandeln" pages 389 to 393**

**IEEE PHOTOVOLTAIC SPECIALISTS CONFERENCE, 5 to 8 June 1978, Washington, D.C.**
**L. M. FRAAS et al. "Design of High Efficiency Monolithic Stacked Multijunction Solar Cells" pages 886 to 891**

Courier Press, Leamington Spa, England

The invention relates to tandem solar cells in which, in use, energy passes through a plurality of superimposed layers of photo-responsive materials, each layer being principally responsive to different energy photons.

In the field of solar energy converting devices, the energy from sunlight falling on a device is converted to electrical energy. Since the spectrum of solar energy provides photons of varying energies, a class of devices has been developed known as tandem solar cells wherein the sunlight passes serially through several regions of the solar cell and each separate region is tailored for efficient conversion to electrical energy of photons of a specific energy level. Tandem solar cells are usually constructed with regions of different energy gaps with a higher energy gap region adjacent to the surface through which the light enters the device and the lower energy gap regions are positioned further into the device since the lower energy photons penetrate deeper.

Tandem solar cell structures have appeared in the art wherein materials of different bandgaps are used in different regions and such structures are shown, for example, in US—A—4,179,702 and US—A—4,017,332. Further, a tandem cell has been made up using polycrystalline semiconductor material which exhibits a higher energy gap for the upper layer and using monocrystalline semiconductor material which exhibits a lower energy gap for the lower layer. The efficiency and the circuit performance of such structures, however, have been limited heretofore in the art by the light transmission properties and the electrical properties of the structures. Moreover, in order to connect the separate solar cell regions in the tandem structure into electrical series, it is necessary to provide some means of making ohmic contact to each region, in a way which does not attenuate the light. Tunnel junctions are the most commonly suggested means for making the ohmic connection. For example, Fraas and Knechtli, in the 13th IEEE *Photovoltaics Specialists Conference*, page 886, show a tandem structure consisting of a p/n GaAs solar cell and a p/n Ge solar cell connected by an $n^+/p^+$ GaAs tunnel junction.

According to the invention, a tandem solar cell in which, in use, energy passes through a plurality of superimposed layers of photo-responsive materials, each layer being principally responsive to different energy photons, is characterised by a crystalline semiconductor substrate layer having a photo-responsive junction associated therewith, an optically transparent conducting layer over the crystalline layer, an amorphous silicon light receiving layer over the optically transparent conducting layer and having a photo-responsive junction associated therewith, and ohmic contacts to the amorphous silicon layer and the crystalline substrate layer, respectively.

Preferably, the transparent conducting layer is of indium tin oxide or tin oxide or tin antimony oxide or cadmium stannate or zinc oxide.

The described embodiment of the invention is a tandem photovoltaic cell comprised of two photo-responsive junctions with a lower layer of a narrower bandgap crystalline material separated from a cover layer of a wider bandgap amorphous photo-responsive material by an optically transparent layer, such as indium tin oxide, that operates to form a rectifying contact to the crystalline material an an ohmic contact to the amorphous material.

When the structure is made of ribbon silicon overlaid with indium tin oxide which in turn is coated with plasma-deposited silicon, a high performance cell using inexpensive materials is the result.

The invention is directed to a structure wherein the two fundamental limits to the efficiency of solar cells, are reduced, i.e. the loss due to insufficient energy photons for conversion and the loss due to excess energy photons for conversion.

The tandem structure where amorphous semiconductor having a wider bandgap is placed on top of crystalline semiconductor with a lower bandgap in an electrical and optical configuration wherein the intermediate transparent conductor such as indium tin oxide serves for both electrical and optical properties provides an efficient approach to the solution of the problem, without incurring the difficulty or expense of providing a tunnel p/n junction.

It has been found that the crystalline material can be acceptably provided using the dendritic or ribbon type of material or in some cases by vapour depositing the material on a foreign substrate. The amorphous type of semiconductor material can be applied by such coating type techniques as sputtering, evaporation, plasma deposition, and low temperature vapour growth. An extremely efficient cell of the amorphous and crystalline type in accordance with the invention, can be made using the optical properties of indium tin oxide to provide an optically transparent electrical connecting layer between the crystalline substrate and the amorphous surface layer. The indium tin oxide has the property that it will form an ohmic contact with the amorphous material and will form a rectifying junction with p-type crystalline material or an ohmic contact with n-type crystalline material.

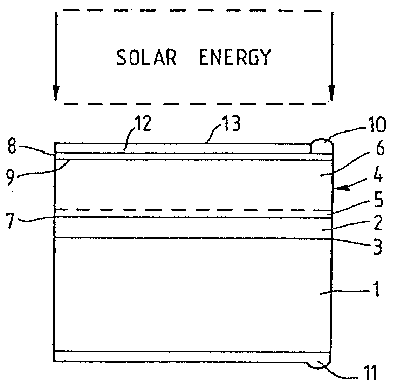

The scope of the invention is defined by the appended claims; and how it can be carried into effect is hereinafter particularly described with reference to the accompanying drawing; which shows a schematic illustration of the layers of a tandem solar cell according to the invention.

A tandem solar cell comprises a substrate layer 1 of crystalline silicon such as ribbon silicon. The ribbon silicon is of p-conductivity type with a doping density in the vicinity of $10^{16}$ atoms per cm$^3$. An intermediate layer 2 of indium tin oxide is evaporated into contact with the ribbon silicon a photo-responsive rectifying junction 3 with the p-type crystalline layer 1. A layer 4 of amorphous silicon 4 is deposited by plasma deposition over the indium tin oxide layer 2. The amorphous silicon layer 4 contains an n-doped region 5 near the indium tin oxide layer 2 and the remainder of the layer 4 is made an intrinsic region 6. The indium tin oxide layer 2 forms an ohmic contact with the n-doped region 5 of the amorphous silicon layer 4 at the interface 7. A thin metal film 8 which is mostly transparent to visible light is applied by evaporation to the surface of the layer 4 to form a photo-responsive Schottky barrier at the interface 9 with the intrinsic region 6 of the amorphous silicon layer Ohmic contacts in the form of electrodes 10 and 11, are applied to the metal film 8 and to the crystalline layer 1, respectively, by a technique such as evaporation through a mask. The output voltage appears across the electrodes. An antireflecting layer 12 of TiO$_2$ is spray deposited or evaporated over the metal film 8 to minimize optical reflection loss from the surface 13. The electrodes 10 and 11 are edge electrodes, but the bottom electrode 11 may extend across the width of the layer 1 to serve as a reflective layer to reflect long wavelength light back through the silicon, enhancing the efficiency of electrical power generation.

In operation, solar energy strikes the surface 13 and enters the cell. Because the amorphous material of the layer 4 has the higher energy gap the higher energy photons are absorbed within the amorphous layer 4. The lower energy photons pass through the amorphous material and are not significantly attenuated by the optical properties of the indium tin oxide layer 2 so that they are absorbed by the lower bandgap crystalline material of the layer 1. The electrical losses that usually occur in tandem devices are minimized by the electrical properties of the indium tin oxide which provides an ohmic contact at interface 7 to the n-doped region 5 of the amorphous layer 4 and a p/n junction 3 to the crystalline p-type silicon of the layer 1.

The indium tin oxide of the layer 2 also has the property that is will form an ohmic contact to n-conductivity type silicon. This property is advantageous in that should it be desirable to provide a specific type of photo-responsive rectifying junction by a technique such as diffusion in the crystalline silicon material, so that an n-doped region of the layer 1 is in contact with the layer 2, the indium tin oxide will then provide an ohmic contact to both the n-doped region of the crystalline layer 1 and the n-doped region 5 of the amorphous layer 4.

The crystalline silicon material can be drawn by various processes into large area shapes such as ribbons, thereby providing fairly inexpensively a broad light receiving structure.

Other crystalline semiconductor materials such as Ge, GaSb, GaInAs, or InP can be substituted for the crystalline Si. Such materials may be polycrystalline or monocrystalline. Alternatively, several low cost forms of crystalline Si may be used such as ribbon silicon, thin film Si polycrystalline films on foreign substrates, or cast polycrystalline Si.

It has been discovered that the material indium tin oxide has both optical and electrical properties for an excellent solar energy contact to silicon material. Where the crystalline silicon semiconductor material of the layer 1 is p-conductivity type, the indium tin oxide will form a rectifying junction. Where a p/n junction is already present in the layer 1, the indium tin oxide will form an ohmic contact with the n-conductivity type region and with the amorphous silicon. Other conducting transparent materials with properties similar to indium tin oxide can be used. For example, tin oxide is also a transparent conductor and forms a good rectifying junction with n-type crystalline Si. Other examples of transparent conducting materials are tin antimony oxide, cadmium stannate, and zinc oxide.

The photo-responsive amorphous silicon layer 4 can be a n$^+$-intrinsic-p$^+$ version in place of the described n$^+$-intrinsic-Schottky barrier arrangement.

The thickness of the transparent conducting layer can affect the optical properties of the tandem structure because of the differing refractive indices of the crystalline layer, the transparent conducting layer, and the amorphous Si layer. The thickness of the transparent conducting layer should be chosen to minimize optical reflectance from the interface 3 for the wavelengths of light intermediate the amorphous Si bandgap wavelength and the crystalline material bandgap wavelength. A computer analysis is required to predict the optical effects accurately, but an approximation can be made using quarter wavelength principles. To minimize reflection for wavelengths between 0.7 $\mu$m and 1.1 $\mu$m, the transparent conducting layer, with a refractive index n, should have a thickness t approximately equal to the wavelength divided by four times the refractive index.

For a refractive index of 2, this gives between 0.0875 $\mu$m and 0.1375 $\mu$m, say, 0.125 $\mu$m. Thick-nesses somewhat higher, for example, 0.2 $\mu$m, can be tolerated and thicknesses as small as 0.01 $\mu$m may be acceptable because of the optical cavity nature of the amorphous Si/transparent conducting layer/crystalline substrate sandwich.

The conducting transparent material has good optical properties for not attenuating photons that pass through it. The amorphous silicon has a wider bandgap than the crystalline silicon and lends itself to application by coating types of deposition processes. It has been found that amorphous silicon exbibits a bandgap of 1.6 to 2 electron volts depending on the nature of the deposition process employed, whereas crystalline silicon, whether polycrystalline or monocrystalline, exhibits a bandgap of the vicinity of 1.1 electron volts. The structure described provides a device with an efficiency of the order of 7—9% for each part, with an overall efficiency of 14—18%.

There has been described a low cost high efficiency tandem solar cell wherein crystalline material and amorphous silicon material having different bandgaps are joined by an indium tin oxide intermediate layer which operates to provide a structure with improved optical and electrical properties that can be fabricated using not only inexpensive materials but also broad area inexpensive processes.

## Claims

1. A tandem solar cell in which, in use, energy passes through a plurality of superimposed layers (1, 4) of photo-responsive materials, each layer (1, 4) being principally responsive to different energy photons, characterised by a crystalline substrate layer (1) having a photo-responsive junction (3) associated therewith, an optically transparent conducting layer (2) over the crystalline semiconductor layer (1), an amorphous silicon light receiving layer (4) over the optically transparent conducting layer (2) and having a photo-responsive junction (9) associated therewith, and ohmic contacts to the amorphous silicon layer (4) and the crystalline substrate layer (1), respectively.

2. A cell according to claim 1, in which the crystalline substrate layer (1) is of silicon.

3. A cell according to claim 1 or 2, in which the photo-responsive junction (3) associated with the crystalline substrate layer (1) is on the light-receiving surface thereof.

4. A cell according to claim 3, in which the optically transparent conducting layer (2) forms the photo-responsive junction (3) associated with the crystalline substrate layer (1).

5. A cell according to any preceding claim, in which the the optically transparent conducting layer (2) is of indium tin oxide or tin oxide or tin antimony oxide or cadmium stannate or zinc oxide.

6. A cell according to claim 5, in which the optically transparent conducting layer (2) is of indium tin oxide.

7. A cell according to any preceding claim, in which the optically transparent conducting layer (2) has a thickness in the range 0.01 $\mu$m to 0.2 $\mu$m.

8. A cell according to any preceding claim, in which the amorphous silicon layer (4) forms an ohmic contact with the optically transparent conducting layer (2).

9. A cell according to any preceding claim, in which the photo-responsive junction (9) associated with the amorphous silicon layer (4) is on the light receiving surface thereof.

10. A cell according to claim 9, in which the photo-responsive junction (9) associated with the amorphous silicon layer (4) is a Schottky barrier.

11. A cell according to claim 10, in which a thin metal film (8) forms the Schottky barrier at an interface with the amorphous silicon layer (4).

## Revendications

1. Cellule solaire composite dans laquelle, en cours d'utilisation, de l'énergie traverse plusieurs couches superposées (1, 4) de matériau photosensible, chacune de couches (1, 4) répondant principalement à différents photons d'énergie, caractérisée en ce qu'elle comporte une couche cristalline (1) constituant un substrat et à laquelle est associée une jonction photosensible (3), une couche conductrice optiquement transparente (2) recouvrant la couche semiconductrice cristalline (1), une couche en silicium amorphe (4) qui reçoit la lumière et qui est disposée au-dessus de la couche conductrice optiquement transparente (2) et à laquelle est associée une jonction photosensible (4), et des contacts ohmiques établis avec la couche en silicium amorphe (4) et la couche cristalline formant substrat (1), respectivement.

2. Cellule selon la revendication 1, caractérisée en ce que la couche cristalline formant substrat (1) est en silicium.

3. Cellule selon la revendication 1 ou 2, caractérisée en ce que la jonction photosensible (3) associée à la couche cristalline formant substrat (1) se trouve sur la surface de celle-ci qui reçoit la lumière.

4. Cellule selon la revendication 3, caractérisée en ce que la couche conductrice optiquement transparente (2) constitue la jonction photosensible (3) associée à la couche cristalline formant substrat (1).

5. Cellule selon l'une quelconque des revendications précédentes, caractérisée en ce que la couche conductrice optiquement transparente (2) est en oxyde d'étain et d'indium ou en oxyde d'étain ou en oxyde d'étain et d'antimoine ou en stannate de cadmium ou en oxyde de zinc.

6. Cellule selon la revendication 5, caractérisée en ce que la couche conductrice optiquement transparente (2) est en oxyde d'indium et d'étain.

7. Cellule selon l'un quelconque des revendications précédentes, caractérisée en ce que la couche conductrice optiquement transparente (2) présente une épaisseur comprise entre 0,01 et 0,2 microns.

8. Cellule selon l'une quelconque des revendications précédentes, caractérisée en ce que la couche en silicium amorphe (4) constitue un contact ohmique avec la couche conductrice optiquement transparente (2).

9. Cellule selon l'une quelconque des revendications précédentes, caractérisée en ce que la jonction photosensible (9) associée à la couche en silicium amorphe (4) se trouve sur la surface de celle-ci qui reçoit la lumière.

10. Cellule selon la revendication 9, caractérisée en ce que la jonction photosensible (9) associée à la couche de silicium amorphe (4) est une barrière de Schottky.

11. Cellule selon la revendication 10, caractérisée en ce qu'un mince film métallique (8) constitue la barrière de Schottky au niveau d'une interface avec la couche de silicium amorphe (4).

## Patentansprüche

1. Tandem-Solarzelle, in der beim Gebrauch Energie durch mehrere einander überlagerte Schichten (1, 4) eines photoempfindlichen Materials fällt, von denen jede grundsätzlich auf Photonen mit anderer Energie anspricht, gekennzeichnet durch eine kristalline Substratschicht (1) mit einem photoempfindlichen Übergang (3), eine optisch transparente leitende Schicht (2) über der kristallinen Halbleiterschicht (1), eine amorphe aus Silizium bestehende Lichtempfangsschicht (4) über der optisch transparenten leitenden Schicht (2) mit einem zugehörigen photoempfindlichen Übergang (9) und ohmsche Kontakte zur amorphen Siliziumschicht (4) beziehungsweise der kristallinen Substratschicht (1).

2. Zelle nach Anspruch 1, in der die kristalline Substratschicht (1) aus Silizium besteht.

3. Zelle nach Anspruch 1 oder 2, in der sich der zur kristallinen Substratschicht (1) gehörende photoempfindliche Übergang (3) auf deren Lichtempfangsfläche befindet.

4. Zelle nach Anspruch 3, in der die optisch transparente Leiterschicht (2) den zur kristallinen Substratschicht (1) gehörenden photoempfindlichen Übergang (3) bildet.

5. Zelle nach einem der vorhergehenden Ansprüche, in der die optisch transparente Leiterschicht (2) aus Indium-Zinnoxyd oder Zinnoxyd oder Zinn-Antimonoxyd oder Cadmium-Stannat oder Zinkoxyd besteht.

6. Zelle nach Anspruch 5, in der die optisch transparente Leiterschicht (2) aus Indium-Zinnoxyd besteht.

7. Zelle nach einem der vorhergehenden Ansprüche, in der die optisch transparente Leiterschicht (2) eine Dicke zwischen 0,01 $\mu$m und 0,2 $\mu$m hat.

8. Zelle nach einem der vorhergehenden Ansprüche, in der die amorphe Siliziumschicht (4) einen ohmschen Kontakt zur optisch transparenten Leiterschicht (2) bildet.

9. Zelle nach einem der vorhergehenden Ansprüche, in der sich der zur amorphen Siliziumschicht (4) gehörende photoempfindliche Übergang (9) auf deren Lichtempfangsfläche befindet.

10. Zelle nach Anspruch 9, in der der zur amorphen Siliziumschicht (4) gehörende photoempfindliche Übergang (9) eine Schottky-Barriere ist.

11. Zelle nach Anspruch 10, in der ein metallischer Dünnfilm (8) die Schottky-Barriere an der Schnittfläche zur amorphen Siliziumschicht (4) bildet.

SOLAR ENERGY